(19)

Europäisches
Patentamt
European
Patent Office
Office européen
des brevets

(11) **EP 4 586 498 A1**

(12) **EUROPEAN PATENT APPLICATION**

(43) Date of publication:
**16.07.2025 Bulletin 2025/29**

(21) Application number: **25151298.4**

(22) Date of filing: **10.01.2025**

(51) International Patent Classification (IPC):
**H03B 5/36** (2006.01)

(52) Cooperative Patent Classification (CPC):
**H03B 5/36**; H03B 2200/0076; H03B 2200/0094

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.01.2024 US 202463620174 P**

(71) Applicant: **Ensign-Bickford Aerospace & Defense
Company
Simsbury, CT 06070 (US)**

(72) Inventor: **JOHNSON, Christopher R.
West Simsbury, 06092 (US)**

(74) Representative: **Harris, Oliver John Richard
Novagraaf UK
Centrum
Norwich Research Park
Colney Lane
Norwich NR4 7UG (GB)**

(54) **REDUNDANT OSCILLATOR WITH SYNCHRONOUS START UP**

(57) A circuits for synchronizing oscillators without settling time include a power supply voltage source (VDD), at least three coupled oscillators having respective inputs connected to a first single node, at least three inverting buffers, each inverting buffer having a respective input connected to an output of a corresponding oscillator of the at least three oscillators, at least three summing resistors, an input side of which is connected to an output side of one and only one of the at least three inverting buffers each summing resistor having a first end connected to an output of a corresponding inverting buffer of the at least three inverting buffers, and a combined output created by connecting second ends of the at least three summing resistors to a single second node.

**FIG. 1**

EP 4 586 498 A1

## Description

CROSS-REFERENCE TO RELATED APPLICATIONS

This application claims priority to U.S. provisional application No. 63/620,174 filed on January 12, 2024, the content of which is incorporated herein by reference in its entirety.

TECHNICAL FIELD

The subject matter disclosed herein relates to redundant oscillators, and more specifically to a circuit that creates a valid digital clock from a set of redundant oscillators even when the output of one or more oscillators is disturbed.

BACKGROUND OF THE DISCLOSURE

A digital clock is an electronic circuit that generates a constant, precise frequency signal to synchronize the operations of digital systems. The accuracy and stability of a digital clock is crucial, as it directly impacts the performance and reliability of the digital system it controls. Ionizing radiation is a major source of disturbances for digital clocks operating in radiation-rich environments such as earth orbit. In order to assure a digital system correctly processes and transfers information when operating in these environments, a digital clock must remain undisturbed in the presence of radiation.

SUMMARY

Embodiments of the present disclosure include circuits for synchronizing oscillators without settling time. According to one aspect, a circuit can include a power supply voltage source (VDD), at least three coupled oscillators having respective inputs connected to a first single node, at least three inverting buffers, each inverting buffer having a respective input connected to an output of a corresponding oscillator of the at least three oscillators, at least three summing resistors, an input side of which is connected to an output side of one and only one of the at least three inverting buffers each summing resistor having a first end connected to an output of a corresponding inverting buffer of the at least three inverting buffers, and a combined output created by connecting second ends of the at least three summing resistors to a single second node.

The at least three oscillators can comprise a CMOS unbuffered inverter, a bias resistor, a crystal, an output resistor connecting to the crystal input, a crystal input capacitor, and a crystal output capacitor. Each of the at least three inverting buffers can comprise a CMOS unbuffered CMOS inverter.

The at least three oscillators can oscillate at a similar frequency based at least in part on the crystals of the at least three oscillators having a similar resonant frequency, the crystal input capacitors of the at least three oscillators having a similar capacitance, the crystal output capacitors of the at least three oscillators having a similar capacitance, a stray capacitance in the physical implementation of the circuit, and the output resistors of the at least three oscillators having a similar resistance.

The combined output can start up synchronously without additional settling time after application of power in response to the second ends of the at least three summing resistors being connected to the single second node at the combined output and the at least three oscillators being connected to the single first node at inputs to each of the at least three crystals.

The circuit can further include a processor configured to prevent an upset to one or more of the at least three oscillators or an upset to one or more of the at least three inverting buffers from causing the combined output voltage level from crossing a discrimination threshold.

The discrimination threshold can be based at least in part on the power supply voltage, for example the discrimination threshold can be half of the power supply voltage (VDD).

BRIEF DESCRIPTION OF THE DRAWINGS

FIG. 1 is a schematic of a circuit for three synchronized oscillators, in accordance with one or more embodiments of the current disclosure.

FIG. 2 is a logical diagram of a dual unbuffered CMOS inverter chip, in accordance with one or more embodiments of the current disclosure.

FIG. 3A is an image of a printed circuit board (PCB) representing an implementation of the circuit of FIG. 1, in accordance with one or more embodiments of the current disclosure.

FIG. 3B is another image of the PCB representing an implementation of the circuit of FIG. 1, in accordance with one or more embodiments of the disclosure.

FIG. 3C is another image of the PCB representing an implementation of FIG. 1, in accordance with one or more embodiments of the current disclosure.

FIG. 4A is an image of a test bench used to test the PCB of the three synchronized oscillators, in accordance with one or more embodiments of the current disclosure.

FIG. 4B is an image of the PCB of three synchronized oscillators in a thermal chamber with a resistive probe connected to PCB, in accordance with one or more embodiments of the current disclosure.

FIG. 4C is an image of a module supplying power and providing forced upset control to the PCB, an adapter connecting the module to a twisted-pair flat cable, and an oscilloscope trigger source for monitoring an upset enable, in accordance with one or more embodiment of the current disclosure.

FIG. 5 is an image from a display of a frequency counter of a maximum measured period and a minimum measured period of a combined output from the PCB over a range of power supply voltages, temperatures, and forced upsets.

FIG. 6 is an image of the combined output waveform from the PCB during a forced upset experienced by the synchronized oscillators on the PCB operating at a voltage of 3.3 volts VDD in the thermal chamber at -50 degrees Celsius, in accordance with one or more embodiments of the current disclosure.

FIG. 7 is an image of the combined output waveform from the PCB during a forced upset experienced by the synchronized oscillators on the PCB operating at a voltage of 3.3 volts VDD in the thermal chamber at 100 degrees Celsius, in accordance with one or more embodiments of the current disclosure.

FIG. 8 is an image of the combined output waveform from the PCB during a forced upset experienced by the synchronized oscillators on the PCB operating at a voltage of 2.5 volts VDD in the thermal chamber at 100 degrees Celsius, in accordance with one or more embodiments of the current disclosure.

FIG. 9A is an image of the combined output waveform from the PCB showing the oscillators synchronized at 20 MHz as the power supply ramps from zero volts to 2.0 volts, in accordance with one or more embodiments of the current disclosure.

FIG. 9B is an image of the combined output waveform from the PCB showing the oscillators synchronized at 20 MHz as the power supply ramps from zero volts to 2.0 volts, in accordance with one or more embodiments of the current disclosure.

FIG. 9C is an image of the combined output waveform from the PCB showing the oscillators synchronized at 20 MHz as the power supply ramps from zero volts to 2.0 volts, in accordance with one or more embodiments of the current disclosure.

FIG. 10A is an image of the combined output waveform from the PCB with synchronized oscillators operating at 20 MHz as the power supply voltage ramps from zero to 2.0 volts and the oscillators start up in a thermal chamber at ambient temperature, in accordance with one or more embodiments of the current disclosure.

FIG. 10B is an image of the combined output waveform from the PCB with synchronized oscillators operating at 20 MHz as the power supply voltage ramps from zero to 3.3 volts and the oscillators start up in a thermal chamber at ambient temperature, in accordance with one or more embodiments of the current disclosure.

FIG. 10C is an image of the combined output waveform from the PCB with synchronized oscillators operating at 20 MHz as the power supply voltage ramps from zero to 4 volts and the oscillators start up in a thermal chamber at ambient temperature, in accordance with one or more embodiments of the current disclosure.

FIG. 10D is an image of the combined output waveform from the PCB with synchronized oscillators operating at 20 MHz as the power supply voltage ramps from zero to 2.0 volts and the oscillators start up in a thermal chamber at 100 degrees Celsius, in accordance with one or more embodiments of the current disclosure.

FIG. 10E is an image of the combined output waveform from the PCB with synchronized oscillators operating at 20 MHz as the power supply voltage ramps from zero to 2.5 volts and the oscillators start up in a thermal chamber at 100 degrees Celsius, in accordance with one or more embodiments of the current disclosure.

FIG. 10F is an image of the combined output waveform from the PCB with synchronized oscillators operating at 20 MHz as the power supply voltage ramps from zero to 3.3 volts and the oscillators start up in a thermal chamber at 100 degrees Celsius, in accordance with one or more embodiments of the current disclosure.

FIG. 10G is an image of the combined output waveform from the PCB with synchronized oscillators operating at 20 MHz as the power supply voltage ramps from zero to 4.0 volts and the oscillators start up in a thermal chamber at 100 degrees Celsius, in accordance with one or more embodiments of the current disclosure.

FIG. 10H is an image of the combined output waveform from the PCB with synchronized oscillators operating at 20 MHz as the power supply voltage ramps from zero to 2.0 volts and the oscillators start up in a thermal chamber at -50 degrees Celsius, in accordance with one or more embodiments of the disclosure.

FIG. 10I is an image of the combined output waveform from the PCB with synchronized oscillators operating at 20 MHz as the power supply voltage ramps from zero to 2.5 volts and the oscillators start up in a thermal chamber at -50 degrees Celsius, in accordance with one or more embodiments of the disclosure.

FIG. 10J is an image of the combined output waveform from the PCB with synchronized oscillators operating at 20 MHz as the power supply voltage ramps from zero to 4.0 volts and the oscillators start up in a thermal chamber at -50 degrees Celsius, in accordance with one or more embodiments of the disclosure.

FIG. 11 is multiple images from a frequency counter display of showing the maximum and minimum measured periods of the waveform from the PCB with synchronized oscillators across a range of power supply voltages, thermal chamber temperatures, and forced upsets.

DETAILED DESCRIPTION

As shown and described herein, various features of the disclosure will be presented. Various embodiments may have the same or similar features and thus the same or similar features may be labeled with the similar reference numerals. Although similar reference numbers may be used in a generic sense, various embodiments will be described and various features may include changes, alterations, modifications, etc. as will be appreciated by those of skill in the art, whether explicitly described or otherwise.

A Single Event Upset (SEU) is a momentary disturbance in the output of a semiconductor-based electronic device caused by high-energy radiation particles colliding with the crystal lattice in the digital clock circuit. To ensure reliable operation, digital clock circuits are expected to mitigate the effects of SEUs and thereby avoid system failures. One method of masking SEUs in a digital clock circuit is to combine the outputs of a set of redundant oscillators in a manner that masks the effects of an SEU in one or more of the oscillators. Current approaches for combining redundant oscillators to mask disturbances are characterized by considerable complexity. These systems commonly use start signals, phase comparators, majority logic gates, phase-locked loops, or control processors. This intricate array of components not only multiplies the potential points of failure but also depends on active combining components, which are also vulnerable to SEUs.

Redundant oscillators are expected to be synchronized to run at the same frequency and phase before they can be combined to mask the effect of SEUs on the digital clock output. Current redundant oscillator circuit designs are characterized a settling time after power is applied before the oscillators synchronize. During this settling time, the output of the oscillators cannot be combined to provide a valid digital clock signal.

As discussed above, combined output of redundant oscillators can be used to mask upsets that individual oscillators experience due to radiation, however the combination circuitry usually entails complex designs and has single points of failure. The novel design presented herein leverages the inherent VDD/2 threshold of CMOS digital logic to employ a minimal number of passive combining elements. This approach not only improves reliability but also minimizes susceptibility to SEUs.

The instant disclosure uses a less complex configuration than current redundant oscillator designs. The redundant oscillator design in the instant disclosure does not require a settling period after start-up for the oscillators to synchronize. The design of the redundant oscillator circuit disclosed herein starts up with all of the oscillators being synchronized. The redundant oscillator circuit described herein uses an optimal VDD/2 threshold that is inherent in CMOS logic gates as a discriminator for a set of summed resistors, whereas current redundant oscillator designs as described above use start signals, phase comparators, majority logic gates, phase-locked loops, or control processors in order to mask the effects of an upset to one or more of the redundant oscillators. The redundant oscillator circuit disclosed herein leverages simple discrete Pierce crystal oscillators that are implemented using unbuffered CMOS inverters. The oscillators are coupled at the crystal inputs and coupled through symmetric summing resistors at the output of buffering CMOS inverters as described below. The coupling of CMOS inverter at the crystal inputs and buffer outputs is important in synchronizing the redundant oscillators upon start up and maintaining the rejection, or masking, of the upsets experienced by the crystal oscillators. It is likely that start up behavior is enhanced when the oscillator CMOS inverter and output buffer CMOS inverter are on the same IC die and thus well matched. The unbuffered CMOS inverters used in the oscillators enable the oscillators to operate over a wider voltage range than the oscillators in current redundant oscillator designs, because the oscillators in the instant disclosure are limited only by the voltage range of the unbuffered CMOS inverter.

The novel redundant oscillator digital clock design features oscillators uniquely connected to eliminate the need for settling time for synchronization. This specific connectivity ensures synchronized-at-startup behavior, enabling the generation of a valid digital clock signal as the oscillator voltage reaches the manufacturer-specified minimum unbuffered CMOS inverter operating voltage.

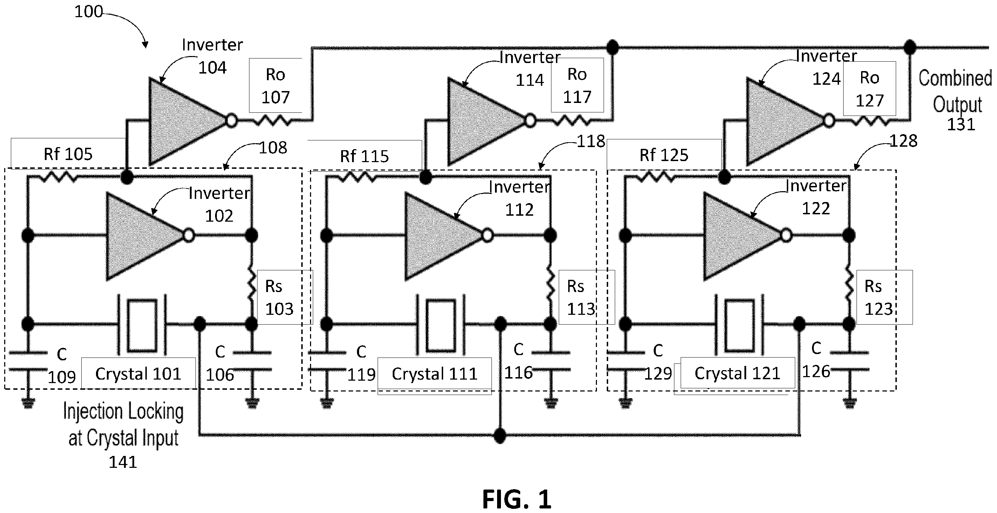

FIG. 1 is a schematic of a circuit for three synchronized oscillators, in accordance with one or more embodiments of the disclosure. Circuit 100 is a redundant oscillator circuit including crystal oscillators 108, 118, and 128, output buffer CMOS inverters 104, 114, and 124, and output combining resistors $R_o$ 107, 117, and 127.

Crystal oscillators 108, 118, and 128 are Pierce style oscillators including crystals 101, 111, and 121, unbuffered CMOS inverters 102, 112, and 122, crystal output capacitors 109, 119, and 129, crystal input capacitors 106, 116, and 126, resistors $R_s$ 103, 113, 123, and resistors $R_f$ 105, 115, 125. Crystals 101, 111, and 121, capacitors 109, 119, 129, 106, 116, 126, stray circuit capacitances in the physical implementation, and resistors $R_s$ 103, 113, and 123 determine the frequency for the Pierce oscillators. The crystals 101, 111, and 121 of the crystal oscillators 108, 118, and 128 can have the same resonant frequency. The input capacitors 106, 116, and 126 of the crystal oscillators 108, 118, and 128 can have the same capacitance. The output capacitors 109, 119, and 129 of the crystal oscillators 108, 118, and 128 can have the same capacitance, a stray capacitance in the physical implementation of the circuit. The output resistors 103, 113, and 123 of the crystal oscillators can have the same resistance. $R_s$ 103, 113, and 123 also limit the power from the output of unbuffered CMOS inverters 102, 112, and 122 transferred to crystals 101, 111, and 121 to avoid damage or long-term degradation and also comprise the oscillator coupling network at the input to crystals 101, 111, and 121. The resistors $R_f$ 105, 115, and 125 are feedback resistors that bias unbuffered CMOS inverters 102, 112, and 122 into the linear region to amplify the feedback through crystals 101, 111, and 121. The feedback resistors 105, 115, and 125 can be referred to herein as bias resistors.

The output from crystal oscillators 108, 118, and 128 are input to unbuffered CMOS inverters 104, 114, and 124. The output of the unbuffered CMOS inverters 104, 114, and 124 are combined output via resistors $R_o$ 107, 117, and 127 to create the combined output 131. Unbuffered CMOS inverters 104, 114, and 124 isolate crystal oscillators 108, 118, and 128 from the loading effects of $R_o$ 107, 117, and 127, and amplify and invert the output of crystal oscillators 108, 118, and 128 to assure that the undisturbed combined output 131 reaches the full VDD and GND CMOS output levels.

The combined output 131 is a resistive sum of the voltage at the output of unbuffered CMOS inverters 104, 114, and 124. When crystal oscillators 108, 118, and 128 are synchronized and no unbuffered CMOS inverters are disrupted, the combined output is a digital signal between VDD and GND oscillating at the synchronized frequency of the oscillators. When any unbuffered CMOS inverter experiences a Single Event Upset (SEU), in the worst case the disrupted CMOS inverter output will be the opposite of the undisturbed outputs. Since $R_o$ 107, 117, and 127 are the same value, Ohm's Law shows that for 3 redundant oscillators a disrupted CMOS inverter will change a GND output level to a VDD/3 output level or a VDD output level to a 2/3 VDD output level. When using a standard VDD/2 CMOS logic threshold on the combined output 131, disruptions on any one of unbuffered CMOS inverters 102, 112, 122, 104, 114, or 124 will be masked. In general, with N oscillators and the disruption of a single unbuffered CMOS inverter, the combined output level varies between ((N-1)/N)) * VDD and (1/N) * VDD. An embodiment with N oscillators can thus tolerate disruption of floor((N+1)/2) - 1 CMOS inverters, where floor(x) refers to the greatest integer less than or equal to x. Due to low probability of radiation disruption of a single unbuffered CMOS inverter, the probability of a second unbuffered CMOS inverter being disrupted before the oscillators are resynchronized after the initial disruption is vanishingly small. Note that in the case of disrupting one of the output buffer CMOS inverters, the oscillator synchronization will be unaffected, so no resynchronization time is required.

In addition to masking the upset of individual unbuffered CMOS inverters, the electrical properties of the unbuffered CMOS inverters 102, 112, 122, 104, 114, and 124 in conjunction with the coupling configuration of the oscillators at the input to crystals 101, 111, and 121 (e.g., at node 141) and outputs of unbuffered CMOS inverters 104, 114, and 124 through output resistors $R_o$ 107, 117, and 127 causes the oscillators 108, 118, and 128 to start up in the synchronized state. When $R_o$ 107, 117, and 127 are not present, the oscillators require a start-up time to synchronize, similar to current redundant oscillator designs.

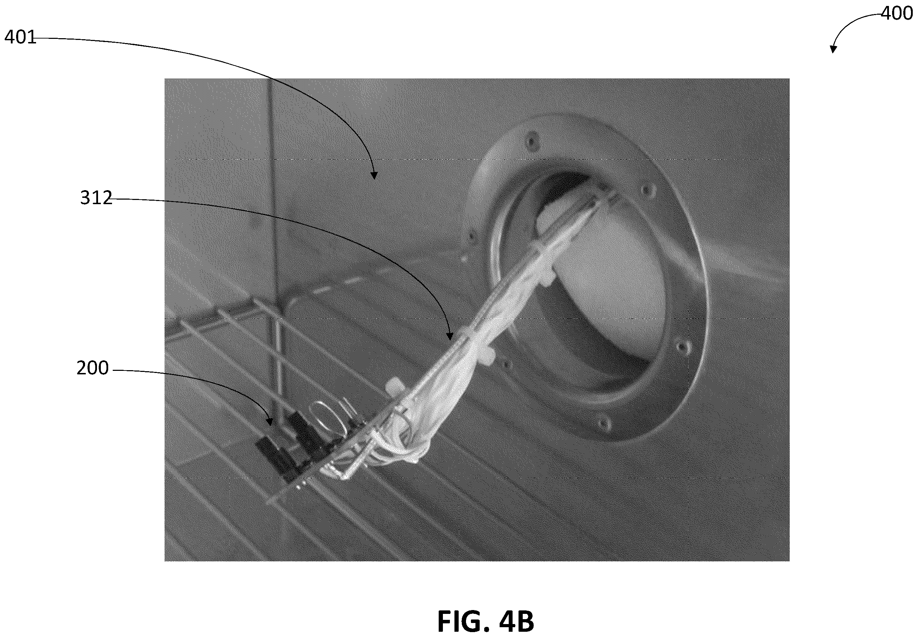

The values for the output resistors $R_o$ 107, 117, and 127, also referred to as summing resistors, can have values that are optimized for a given application. In one embodiment, the output resistors can have a value of 1.33k $\Omega$ and drive a 50 $\Omega$ impedance cable with 50 $\Omega$ termination as discussed below with reference to FIG. 4B for a voltage division ratio that is created by the parallel resistance of the summing resistors, and the cable impedance. The voltage division ratio is based on the number of oscillators in the circuit, the resistance of the output resistors, and the cable impedance. In the embodiment used in FIG. 4B, the output of the circuit on the PCB is connected to a 50$\Omega$ impedance cable and the cable connects to the input of a measurement device which is terminated with 50 $\Omega$. As a result, the impedance of the cable in combination with the parallel resistance formed by the summing resistors, or output resistors, forms a voltage divider with the ratio $\frac{50}{\frac{R_0}{N}+50}$. $N$ is a variable representing the number of oscillators in the circuit. In the embodiment of circuit 100 implemented on the PCB, the voltage division ratio is

$$\frac{50}{\frac{1330}{3}+50} = \frac{1}{0.1014} = 9.86 \approx 10{:}1$$

. This division ratio acts similar to a 10X oscilloscope probe and allows high bandwidth monitoring of the waveforms at the combined output 131 outside thermal chamber 411 in FIG 4B.

When remote monitoring is not required, the values for the output resistors $R_o$ 107, 117, and 127 can have values that are optimized for use without a voltage divider. Without a voltage divider, the full VDD to GND range is available at the input to the digital logic that uses that combined output 131 as a digital clock. The optimal resistance values depend on the capacitance of the digital clock input, the desired power supply current consumption of CMOS inverters 104, 114, and 124, and the clock frequency. The CMOS digital clock input capacitance in combination with the parallel summing resistance of $R_o$ 107, 117, and 127 form an RC filter which limits the maximum clock frequency. While higher resistances use less power, the parallel summing resistance must be low enough to not significantly alter the waveform at the CMOS digital clock input due to RC filtering effects.

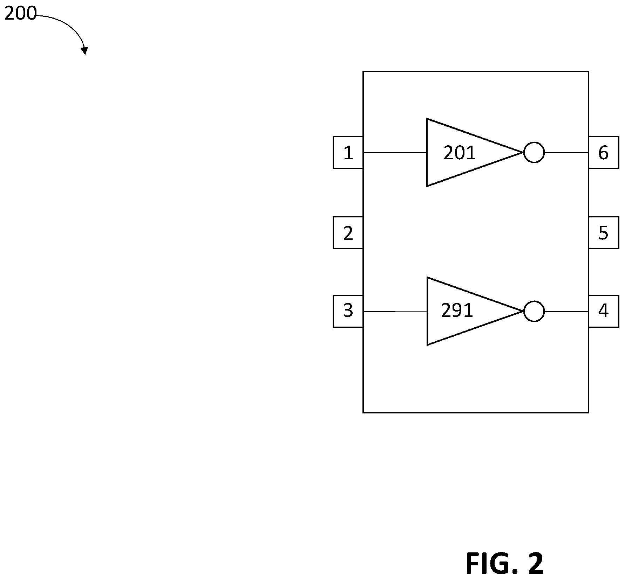

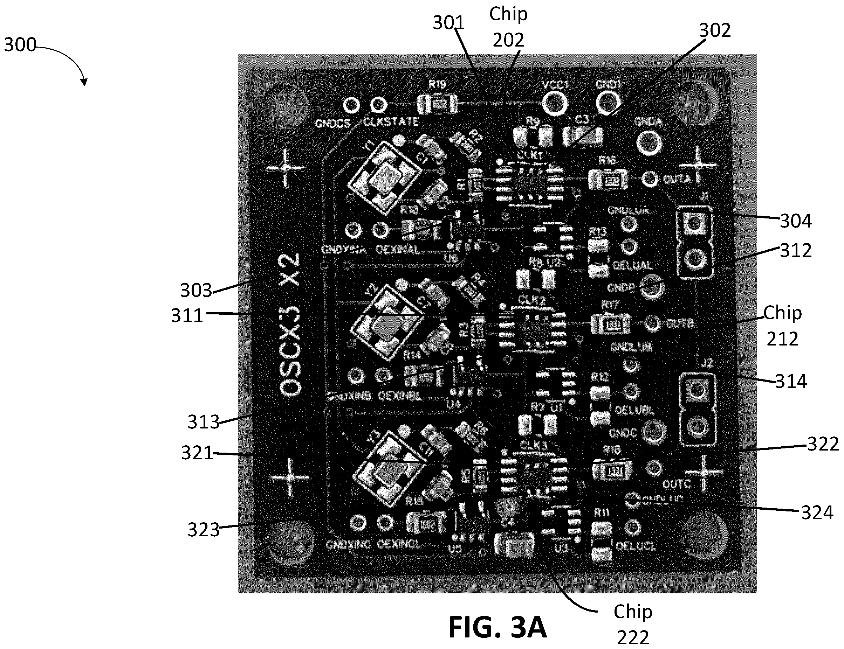

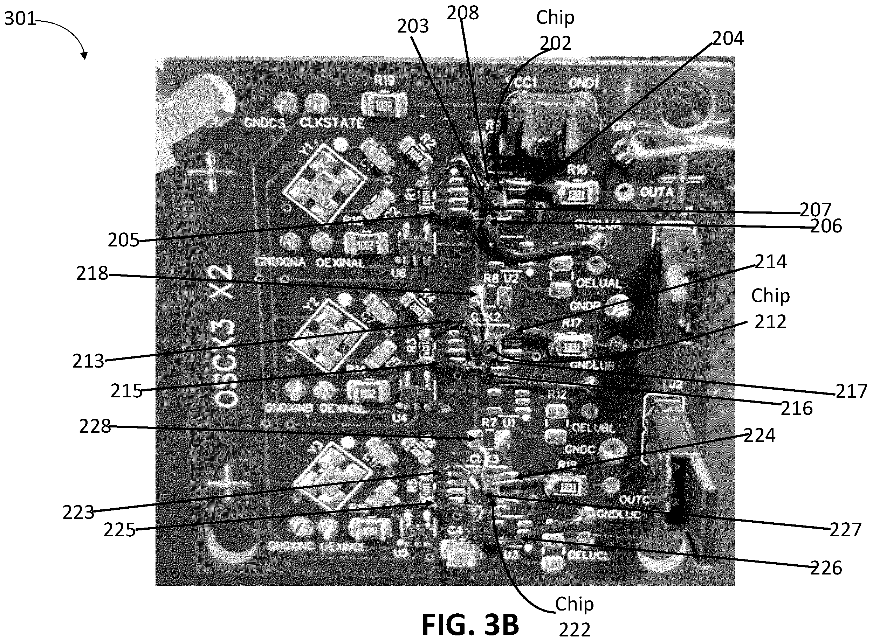

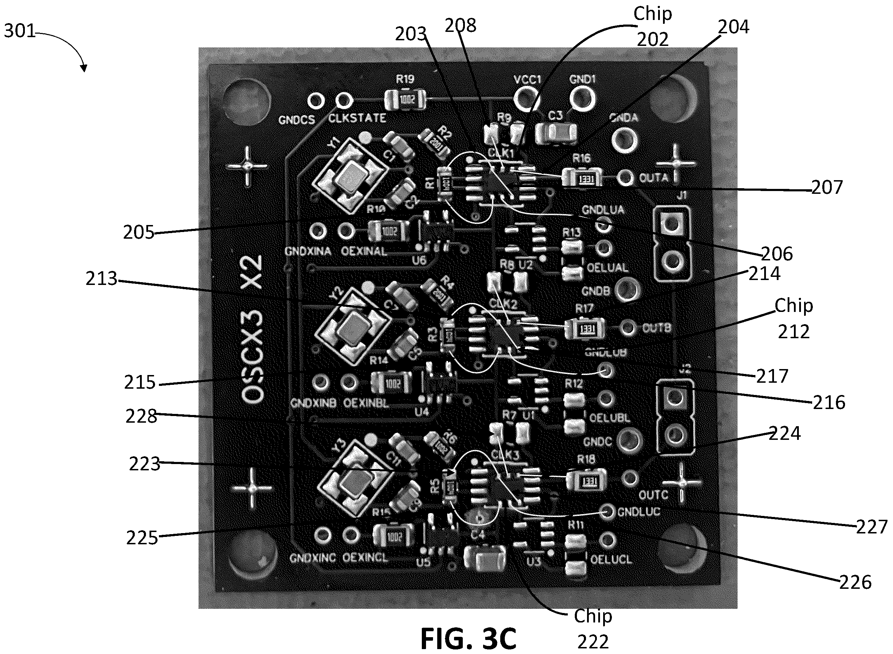

FIG. 2 is a logical diagram of dual unbuffered CMOS inverter chip 200, in accordance with one or more embodiments of the disclosure. Pin 1 is an input to unbuffered CMOS inverter 201, which corresponds to the inputs to CMOS inverters 102, 112, and 122 in FIG. 1. Pin 6 is an output of unbuffered CMOS inverter 201, which corresponds to the outputs of CMOS inverters 102, 112, and 122. The dual unbuffered CMOS inverter chip 200 corresponds to the chips 202, 212, and 222 shown in FIGS. 3A, 3B, and 3C. The unbuffered CMOS inverter 201 can be referred to as the oscillator CMOS inverter. Pin 3 is an input to unbuffered CMOS inverter 291, which corresponds to the inputs to CMOS inverters 104, 114, and 124. Pin 4 is an output of unbuffered CMOS inverter 291, which corresponds to the output of the CMOS inverters 104, 114, and 124.

FIG. 3A is an image of a printed circuit board (PCB) 300 representing an example implementation of the circuit 100, according to an example embodiment of the current disclosure. The PCB 300 includes dual unbuffered CMOS inverter chips, a feedback resistor associated with each of the oscillator CMOS inverters of the dual unbuffered CMOS inverter chips, capacitors associated with each of the oscillator CMOS inverters, a crystal associated with each of the oscillator CMOS inverters, a resistor associated with the output of each of the oscillator CMOS inverters, and a summing resistor associated with each of the output buffer CMOS inverters of the dual unbuffered CMOS inverter chips. Printed circuit board (PCB) 300 includes, among other circuit elements, chips 202, 212, and 222 which correspond to the dual unbuffered CMOS inverter 200 as mentioned above.

Y1 can correspond to crystal 101, R1 can correspond to $R_f$ 105, R2 can correspond to $R_s$ 103, C1 can correspond to C 106, C2 can correspond to C 109, R16 can correspond to $R_o$ 107 and the oscillator CMOS inverter (i.e., CMOS inverter 102) and the output buffer CMOS inverter (i.e., CMOS inverter 104) are included in chip 202. The input pin for the oscillator CMOS inverter in chip 202 is pin 303, and the output pin for the oscillator CMOS inverter in chip 202 is pin 301. The input pin for the output buffer CMOS inverter in chip 202 is pin 304, and the output pin for the output buffer CMOS inverter in chip 202 is pin 302.

Y2 can correspond to crystal 111, R3 can correspond to $R_f$ 115, R4 can correspond to $R_s$ 113, C7 can correspond to C 116, C5 can correspond to C 119, R17 can correspond to $R_o$ 117 and the oscillator CMOS inverter (i.e., CMOS inverter 112) and the output buffer CMOS inverter (i.e., CMOS inverter 114) are included in chip 212. The input pin for the oscillator CMOS inverter in chip 212 is pin 313, and the output pin for the oscillator CMOS inverter in chip 212 is pin 311. The input pin for the output buffer CMOS inverter in chip 212 is pin 314, and the output pin for the output buffer CMOS inverter in chip 212 is pin 312.

Y3 can correspond to crystal 121, R5 can correspond to $R_f$ 125, R6 can correspond to $R_s$ 123, C11 can correspond to C 126, C9 can correspond to C 129, R18 can correspond to $R_o$ 127 and the oscillator CMOS inverter (i.e., CMOS inverter 122) and the output buffer CMOS inverter (i.e., CMOS inverter 124) are included in chip 222. The input pin for the oscillator CMOS inverter in chip 222 is pin 323, and the output pin for the oscillator CMOS inverter in chip 222 is pin 321. The input pin for the output buffer CMOS inverter in chip 222 is pin 324, and the output pin for the output buffer CMOS inverter in chip 222 is pin 322.

FIG. 3B is another image of the PCB 300. The PCB 300 includes connections between the pins of the dual unbuffered CMOS inverter chips, and the feedback resistor associated with each of the oscillator CMOS inverters of the dual unbuffered CMOS inverter chips, the capacitors associated with each of the oscillator CMOS inverters, the crystal associated with each of the oscillator CMOS inverters, the resistor associated with the output of each of the oscillator CMOS inverters, and the summing resistor associated with each of the output buffer CMOS inverters of the dual unbuffered CMOS inverter chips. Resistor R1, which is a feedback resistor, is connected to the input pin 303 of chip 202 via connection 205 and is connected to the output pin 301 via connection 203. The output pin 301 of the oscillator CMOS inverter, is also connected to the input pin 304 of the output buffer CMOS inverter of chip 202 via connection 207. The output pin 302 of the output buffer CMOS inverter of chip 202 is connected to resistor R16 via connection 204. Connection 208 connects the DC supply voltage input of chip 202 to the PCB power supply voltage input. Connection 206 connects the ground pin of chip 202 to the PCB ground input.

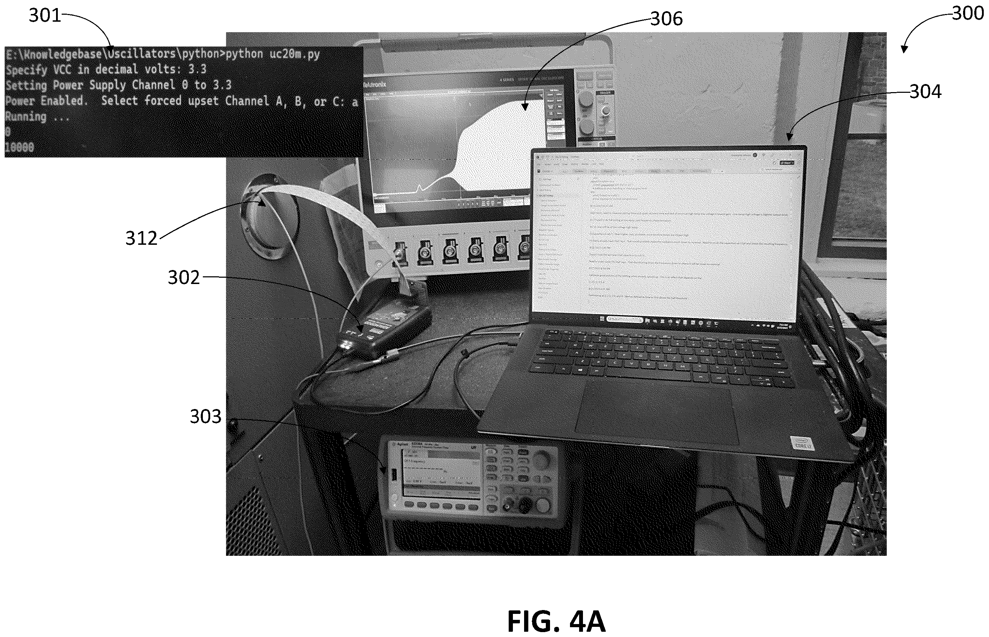

In the PCB 300, the output from resistors R16, R17, and R18 are summed when J1 and J2 are shorted by installing jumpers. Upsets to the oscillator CMOS inverters in the chips 202, 212, and 222 can be forced by inputting low or high inputs to buffers U6, U4, and U5 respectively from an external device such as module 402 in FIG. 4A as discussed below.

FIG. 3C is another image of the PCB 300. FIG.

3C depicts the connections between the pins of the dual unbuffered CMOS inverter chips and the feedback resistor associated with each of the oscillator CMOS inverters of the dual unbuffered CMOS inverter chips, the capacitors associated with each of the oscillator CMOS inverters, the crystal associated with each of the oscillator CMOS inverters, the resistor associated with the output of each of the oscillator CMOS inverters, and the summing resistor associated with each of the output buffer CMOS inverters of the dual unbuffered CMOS inverter chips. FIG. 3C includes lines drawn between the pins of the dual unbuffered CMOS inverter chip illustrating connections between the pins, and lines drawn between the pins of the dual unbuffered CMOS inverter chip and circuit elements on the PCB 300 similar to the connections shown in FIG. 3B. The connections shown in FIG. 3C correspond to the connections in FIG. 1 as well.

FIG. 4A is an image of a test bench used to test the PCB of the three synchronized oscillators, in accordance with one or more embodiments of the disclosure. Image 400A includes a work bench that is used to monitor how the circuit 100 responds across a range of power supply voltages while being exposed to range of temperatures and upsets. Computing device 404 is a laptop that is used to execute instructions that cause module 402 to sweep through a range of operating voltages at VDD that are applied to the circuit 100, and to generate forced upsets that are applied to the oscillators 108, 118, or 128. Screenshot 401 is a screenshot of a script corresponding to the instructions that cause the module 402 to apply a range of operating voltages for VDD to the circuit 100, and that cause the module 402 to generate forced upsets that are applied to the oscillators 108 , 118, or 128. Frequency counter 403 is used to measure and verify the frequency of combined output 131. In some embodiments, the crystals 101, 111, and 121, can have a resonant frequency of 20 megahertz (MHz) causing the combined output 131 to oscillate at a frequency near 20 MHz. Cable 412 can be a coaxial cable with an impedance of 50 $\Omega$. The combination of the output resistors $R_o$ 107, 117, and 127 and the impedance of cable 412 create a 10X resistive probe that is used to monitor the voltage at combined output 131.

FIG. 4B is an image of the PCB 300 with three synchronized oscillators, in accordance with one or more embodiments of the disclosure. FIG. 4B illustrates an image 400B of the PCB 300 in thermal chamber 411 and the cable 412 connected to the PCB 300. More specifically the cable 412 is connected to the combined output 131 of the PCB 300.

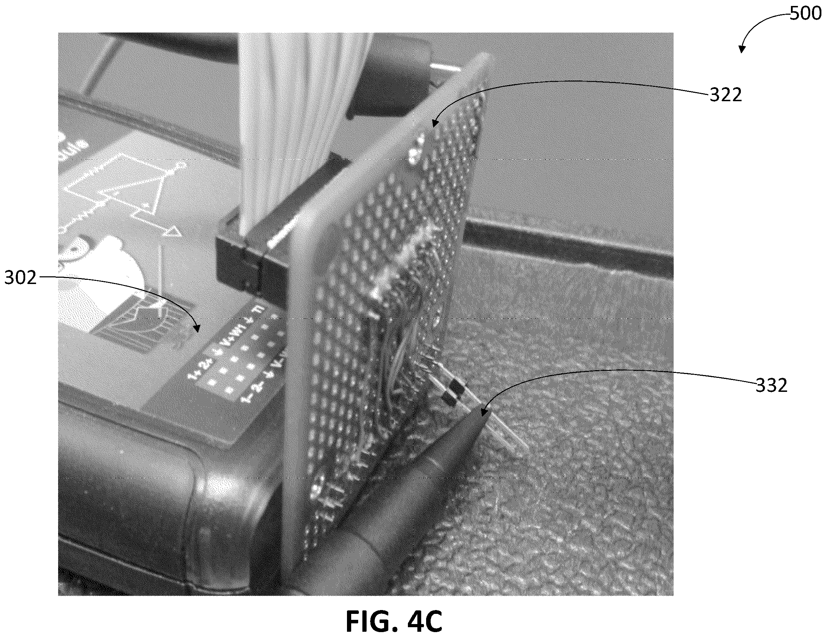

FIG. 4C is an image of a module supplying a power supply voltage (VDD) and forced upset control to the PCB 300, in accordance with one or more embodiments of the disclosure. FIG. 4C illustrates an image 500 of the module 402 that is connected to an adapter 422. Adapter 422 connects the module 402 to the PCB 300 via a twisted-pair flat cable and provides an oscilloscope trigger source 432. The module 402 executes instructions corresponding to script 401 to force an upset lasting 5 microseconds with a burst of 20 MHz square waves, and the module sends signals to the PCB 300 via the twisted-pair flat cable thereby causing one of oscillators 108, 118, or 128 to experience an upset. The oscilloscope trigger source 432 transitions at the end of an upset, thereby causing oscilloscope 406 to record and display the combined output 131 of PCB 300 before, during, and after the upset.

Referring to FIG. 4A, the cable 412 connected to oscilloscope 406 was used to measure the startup time and upset recovery time of the combined output 131 while PCB 300 was inside thermal chamber 411 at temperatures of -50 degrees Celsius, ambient temperature, +50 degrees Celsius, and +100 degrees Celsius. Power supply voltages voltage of 2.0V VDD, 2.5V VDD, 3.3V VDD, and 4.0V VDD, were applied to the CMOS inverters 102, 112, 122, 104, 114, and 124. For all combinations of voltage and temperature, the maximum startup time was less than 2.2 milliseconds and the oscillator CMOS inverters 102, 112, and 122 resynchronization time after a 5 microsecond 20 MHz upset burst CMOS inverter was less than 100 microseconds. Forced upsets recorded at typical CMOS power supply voltages of VDD = 2.5V and VDD = 3.3V show that a VDD/2 logic threshold yields a fault-tolerant clock, with a frequency stability $\pm$21ppm from the average frequency in response to voltage variation, temperature variation, and forced upset.

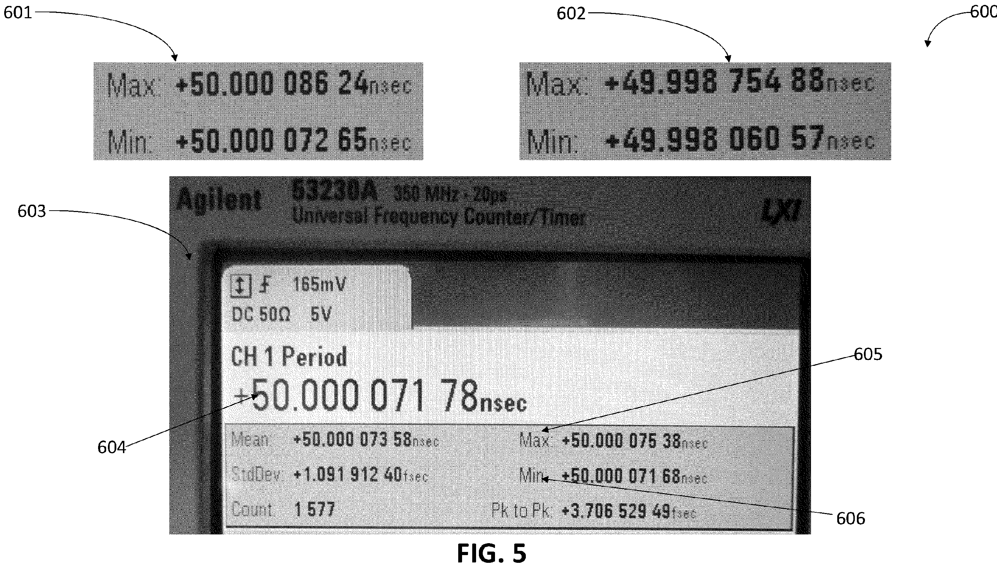

FIG. 5 shows images of the display of the precision frequency meter 403 in FIG. 4A. Image 603 shows the full frequency meter display with currently measured period 604, minimum measured period 606, and maximum measured period 605. Image 601 shows the maximum measured period of 50.00008624 nanoseconds across all power supply voltages, temperatures, and forced upsets. This maximum period corresponds to a minimum frequency of 19.99997 MHz. Image 602 shows the minimum measured period of 49.99806057 nanoseconds across all power supply voltages, temperatures, and forced upsets. This minimum period corresponds to a maximum frequency of 20.00078 MHz. The range of measured frequencies over voltage, temperature, and upsets is thus 20.00037 MHz $\pm$ 21ppm.

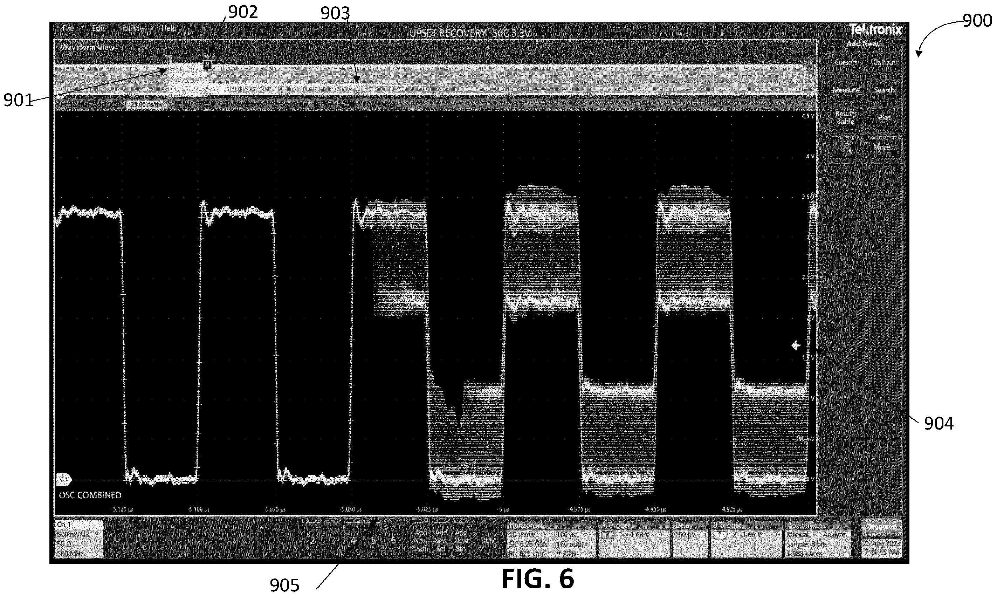

FIG. 6 is an image of the voltage at combined output 131 from $R_o$ 107, 117, and 127 on the PCB 300 showing the effect of a forced upset and resynchronization of one of the synchronized oscillators 108, 118, 128, in accordance with one or more embodiments of the disclosure. In this example, PCB 300 is operating at a voltage of 3.3 volts VDD and thermal chamber 411 is at -50 degrees Celsius. As explained above, module 402 forces an upset by injecting random-phase 5 microsecond 20 MHz square wave bursts into one of the oscillators on the PCB 300 via the twisted-pair flat cable. The oscilloscope 406 triggers on the end of a burst and records the equivalent of the combined output 131 of the PCB 300. Screenshot 900 is a screenshot from oscilloscope 406 showing the overlaid captured waveforms from thousands of individual triggers. The top of screenshot 900 shows the overlaid records of the captures before the burst to the left of time 905, during the burst from time 905 to time 902, and after the burst to the right of time 902. The lower portion of screenshot 900 shows a magnified view of the overlaid captures from the beginning of the burst and is an illustration of how the combined output 131 responds when the state of one of the synchronized oscillators is disrupted. Prior to time 905 the combined output 131 from $R_o$ 107, 117, and 127 on the PCB 300 spans the full VDD to GND range since the oscillators 108, 118, and 128 are all synchronized and the inputs to $R_o$ 107, 117, and 127 are the same. From time 905 until the oscillators resynchronize, the combined output 131 from $R_o$ 107, 117, and 127 spans the range of 1/3 VDD to 2/3 VDD and is centered on VDD/2 = 1.65 volts, due to the resistive divider formed when one $R_o$ 107, 117, or 127 resistor input driven to the opposite digital state of the other two resistor inputs. The discriminating VDD/2 CMOS logic threshold is depicted by arrow 904. Before the upset, during the upset, and as the oscillators resynchronize, the digital clock discriminated by the VDD/2 CMOS input logic threshold remains stable and valid.

After the upset ends at time 902, the voltage of the combined output 131 from $R_o$ 107, 117, and 127 begins to return to the full VDD to GND voltage range. After a period of time subsequent to time 903, the oscillators resynchronize and the voltage of the combined output 131 from $R_o$ 107, 117, and 127 returns to the full VDD to GND voltage range.

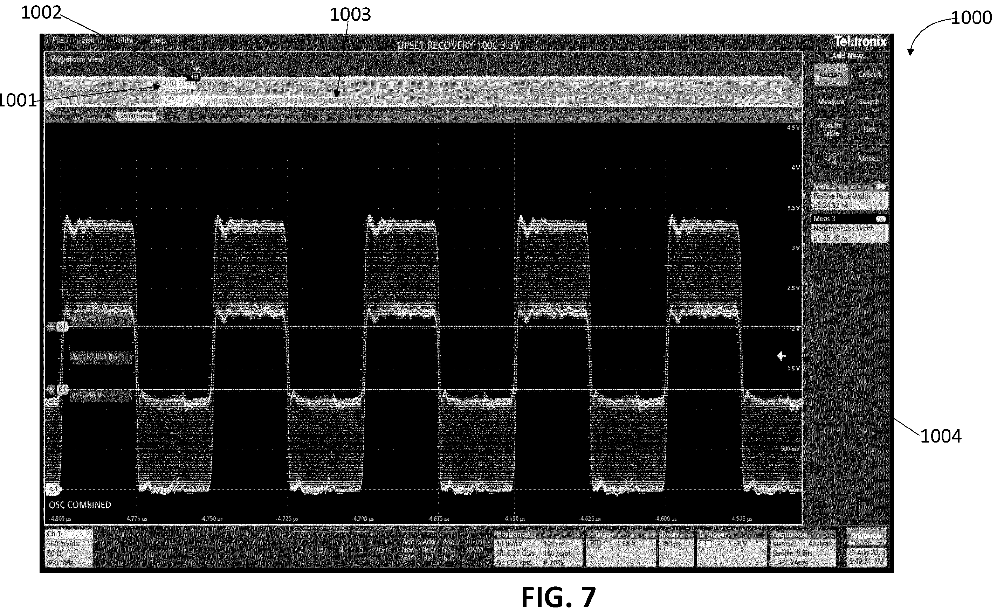

FIG. 7 is an image of the voltage at the combined output 131 from $R_o$ 107, 117, and 127 on the PCB 300 showing the effect of a forced upset and resynchronization of one of the synchronized oscillators 108, 118, 128, in accordance with one or more embodiments of the disclosure. In this example, PCB 300 is operating at a voltage of 3.3 volts VDD and thermal chamber 411 is at 100 degrees Celsius. The oscilloscope 406 triggers on the end of a burst and records the equivalent of the combined output 131 of the PCB 300. Screenshot 1000 is a screenshot from oscilloscope 406 showing the overlaid captured waveforms from thousands of individual triggers. As explained above, prior to start of the burst at time 1001 the combined output from $R_o$ 107, 117, and 127 on the PCB 300 spans the full VDD to GND range since the oscillators 108, 118, and 128 are all synchronized. From time 1001 until the oscillators resynchronize, the combined output 131 from $R_o$ 107, 117, and 127 spans the range of 1/3 VDD to 2/3 VDD and is centered on VDD/2 = 1.65 volts, due to the resistive divider formed when one $R_o$ 107, 117, or 127 resistor input driven to the opposite digital state of the other two resistor inputs. The discriminating VDD/2 CMOS logic threshold is depicted by arrow 1004. Before the upset, during the upset, and as the oscillators resynchronize, the digital clock discriminated by the VDD/2 CMOS input logic threshold remains stable and valid.

After the upset ends at time 1002, the voltage of the combined output 131 from $R_o$ 107, 117, and 127 begins to return to the full VDD to GND voltage range. After a period of time subsequent to time 1003, the oscillators are resynchronized and the voltage of the combined output 131 from $R_o$ 107, 117, and 127 returns to the full VDD to GND voltage range.

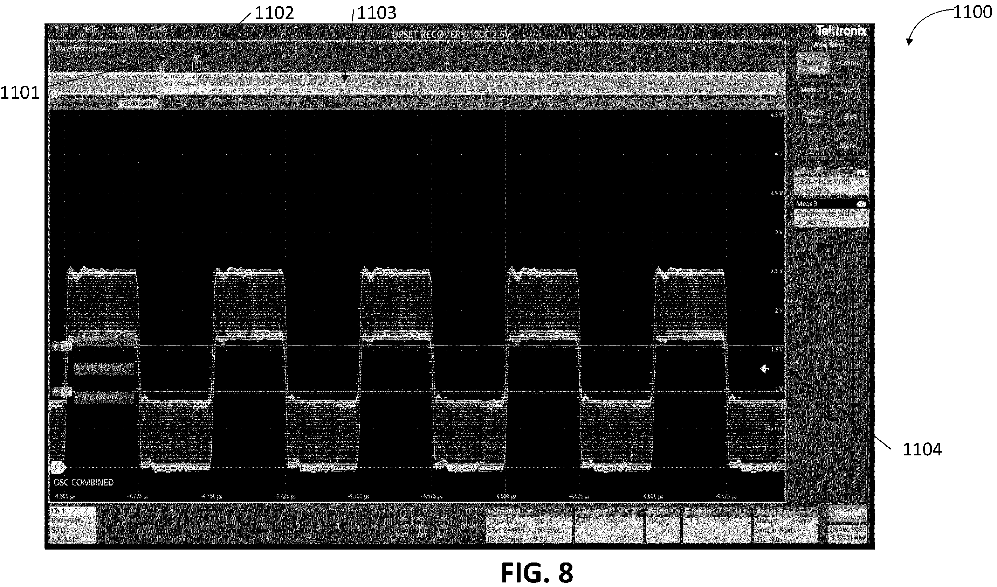

FIG. 8 is an image of the voltage at combined output 131 from $R_o$ 107, 117, and 127 on the PCB 300 showing the effect of a forced upset and resynchronization of one of the synchronized oscillators 108, 118, 128, in accordance with one or more embodiments of the disclosure. In this example, PCB 300 is operating at a voltage of 2.5 volts VDD and thermal chamber 411 is at 100 degrees Celsius. The oscilloscope 406 triggers on the end of a burst and records the equivalent of the combined output 131 of the PCB 300. Screenshot 1100 is a screenshot from oscilloscope 406 showing the overlaid captured waveforms from thousands of individual triggers. As explained above, prior to start of the burst at time 1101 the combined output from $R_o$ 107, 117, and 127 on the PCB 300 spans the full VDD to GND range since the oscillators 108, 118, and 128 are all synchronized. From time 1101 until the oscillators resynchronize, the combined output 131 from $R_o$ 107, 117, and 127 spans the range of 1/3 VDD to 2/3 VDD and is centered on VDD/2 = 1.25 volts, due to the resistive divider formed when one $R_o$ 107, 117, or 127 resistor input driven to the opposite digital state of the other two resistor inputs. The discriminating VDD/2 CMOS logic threshold is depicted by arrow 1104. Before the upset, during the upset, and as the oscillators resynchronize, the digital clock discriminated by the VDD/2 CMOS input logic threshold remains stable and valid.

After the upset ends at time 1102, the voltage of the combined output 131 from $R_o$ 107, 117, and 127 begins to return to the full VDD to GND voltage range. After a period of time subsequent to time 1103, the oscillators are resynchronized and the voltage of the combined output 131 from $R_o$ 107, 117, and 127 returns to the full VDD to GND voltage range.

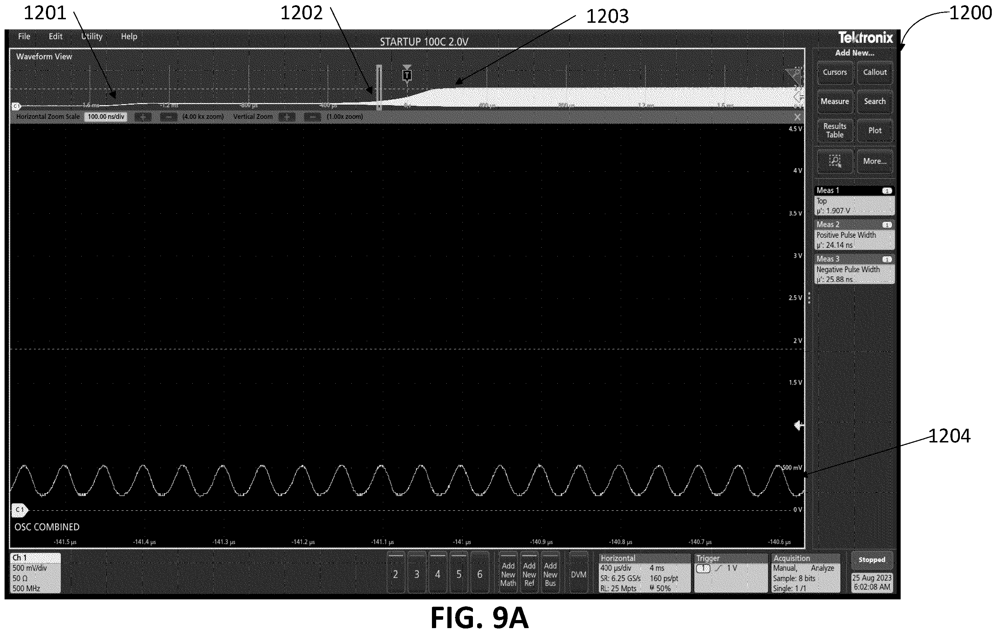

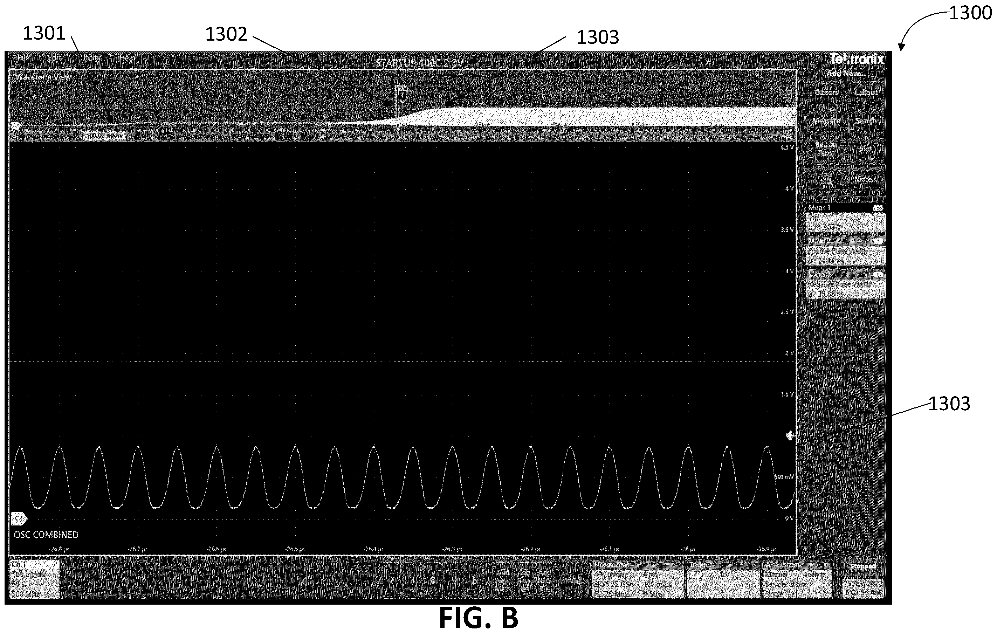

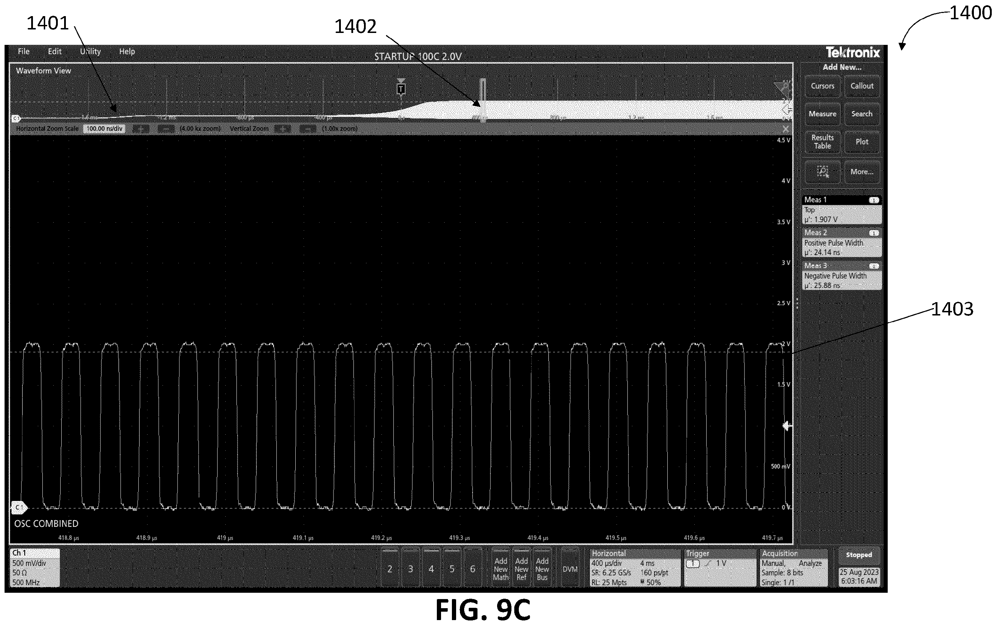

FIG. 9A, FIG. 9B, and FIG. 9C are images of the voltage at the combined output 131 from $R_o$ 107, 117, and 127 on the PCB 300 as the power supply voltage ramps from zero to 2.0 volts and the oscillators synchronously start up, in accordance with one or more embodiments of the disclosure. The top portion of screenshots 1200, 1300, and 1400 from oscilloscope 406 illustrate the full oscillator startup. Times 1201, 1301, and 1401 indicate the start of the ramp of the power supply voltage. The ranges indicated by times 1202, 1302, and 1402 are displayed in lower portion of screenshots 1200, 1300, and 1400 from oscilloscope 406 and show expanded views of selected portions of the startup. The expanded view of the oscilloscope capture in the lower portion of screenshot 1200 from oscilloscope 406 illustrates stable synchronized 20 MHz oscillation starting at less than 500 millivolts. The expanded view of the oscilloscope capture in the lower portion of screenshot 1300 from oscilloscope 406 illustrates the stable synchronized 20 MHz oscillation continuing at approximately 1000 millivolts. The expanded view of the oscilloscope capture in the lower portion of screenshot 1400 from oscilloscope 406 illustrates stable synchronized 20 MHz oscillation at full amplitude of 2.0 volts after the power supply reaches the final 2.0V level. The manufacturer-specified minimum operating voltage of the unbuffered CMOS inverters 102, 112, 122, 104, 114, and 124 used in the test PCB 300 circuit is 1.5V, so FIG. 9A, FIG. 9B, and FIG. 9C show that the combined output 131 from $R_o$ 107, 117, and 127 on the PCB 300 is already in stable synchronized 20 MHz oscillation well before VDD reaches the minimum specified CMOS inverter operating voltage.

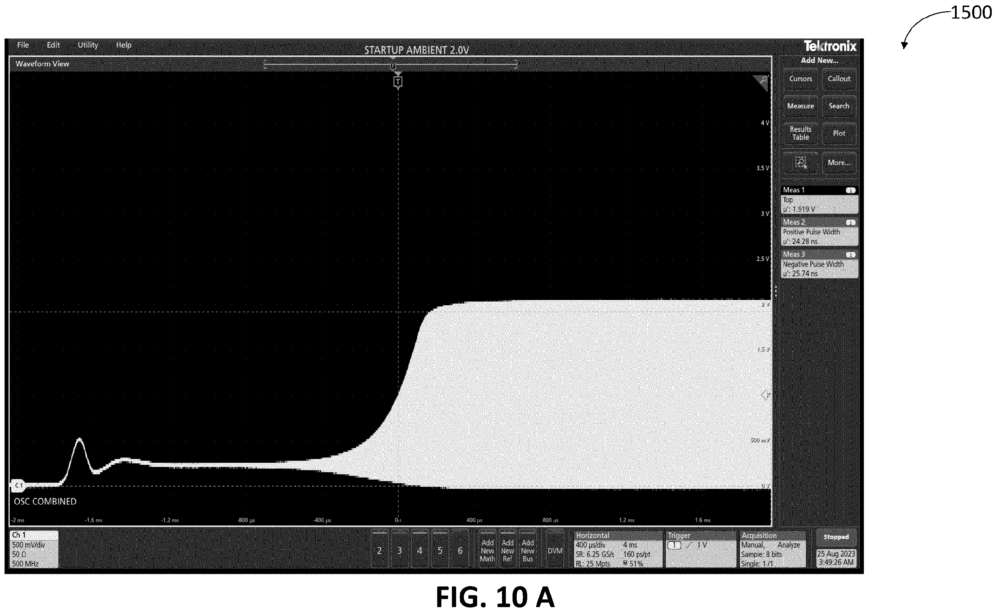

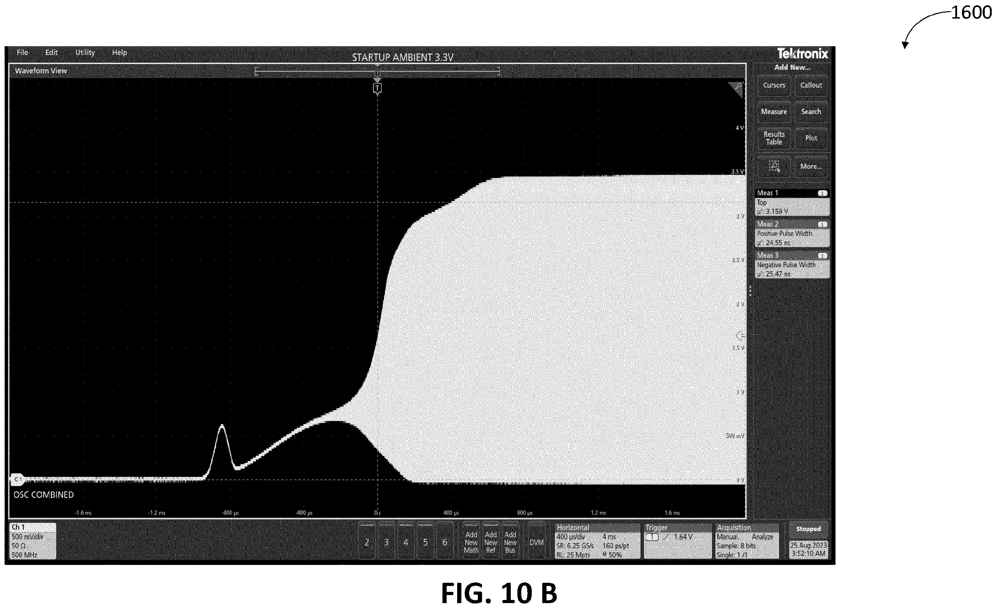

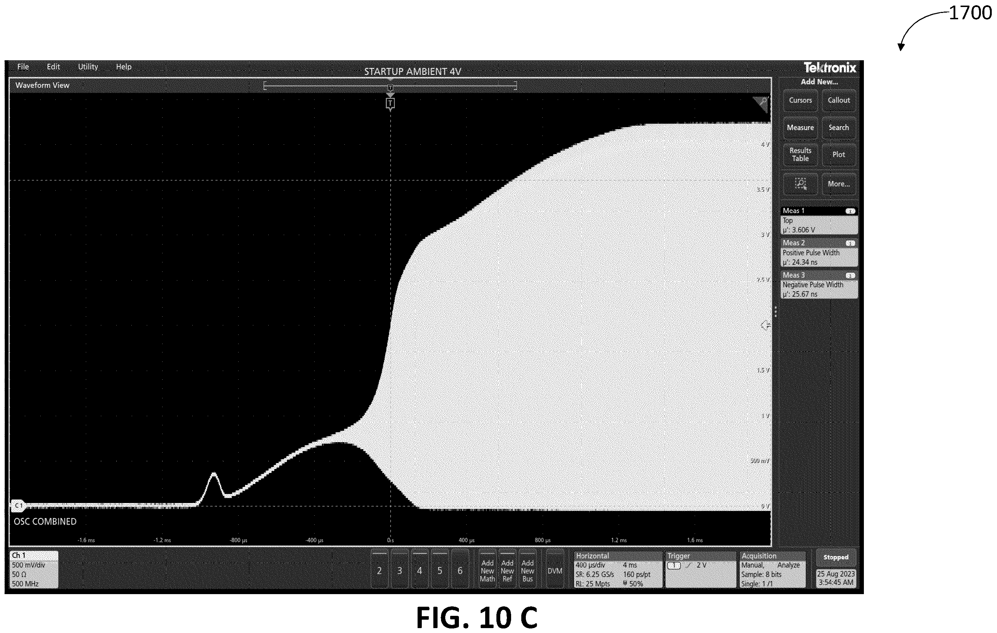

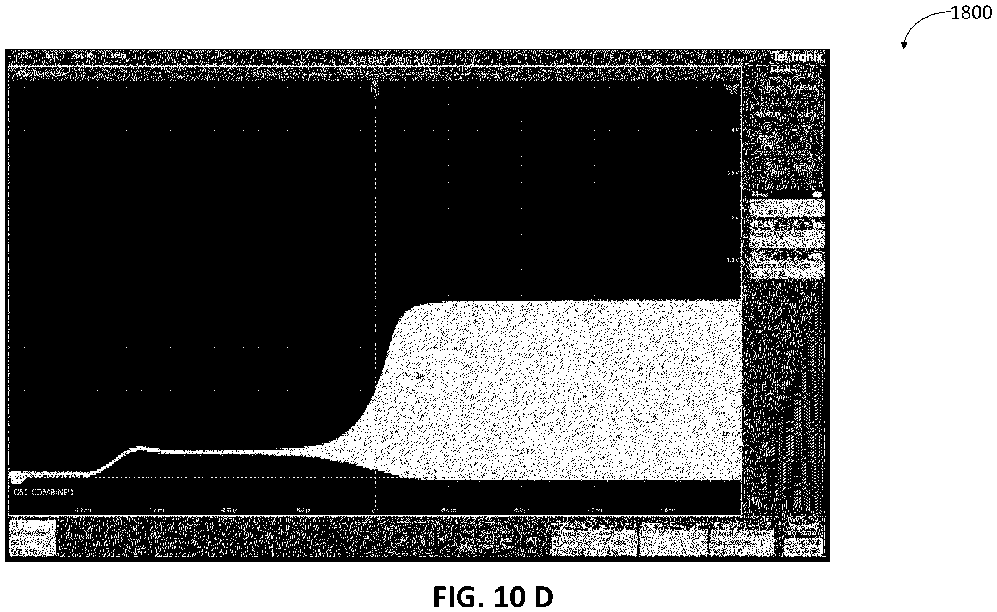

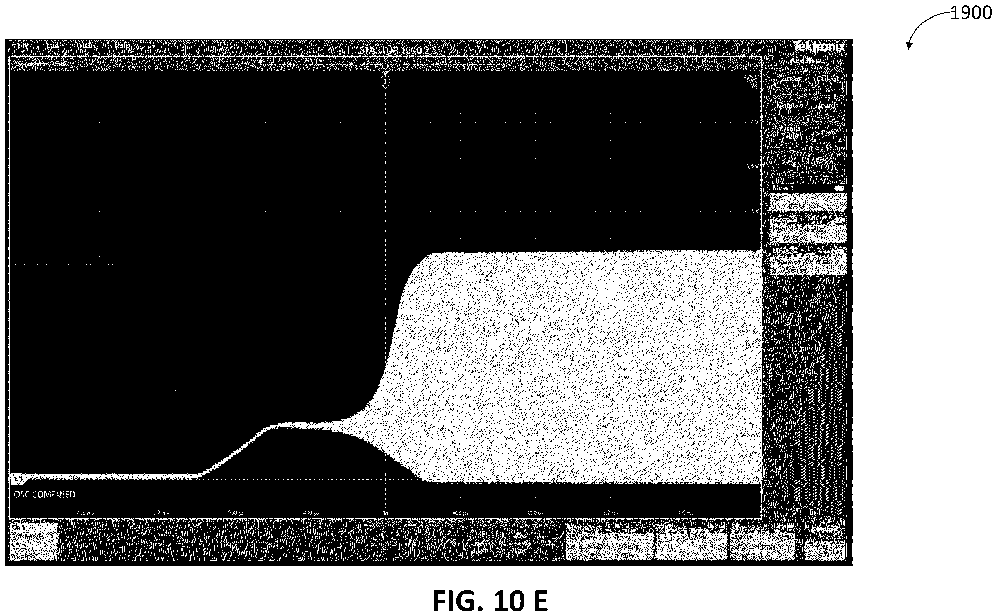

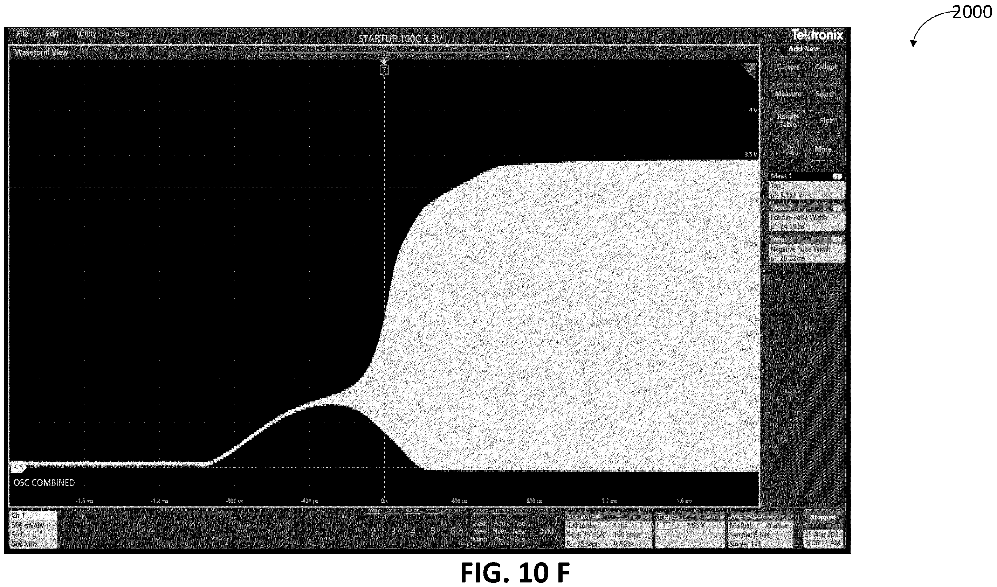

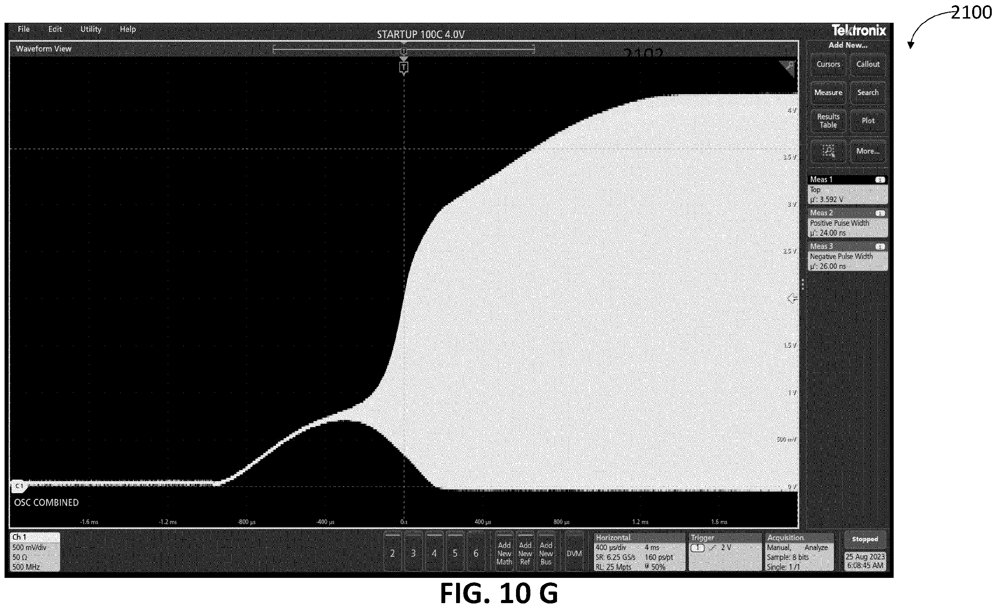

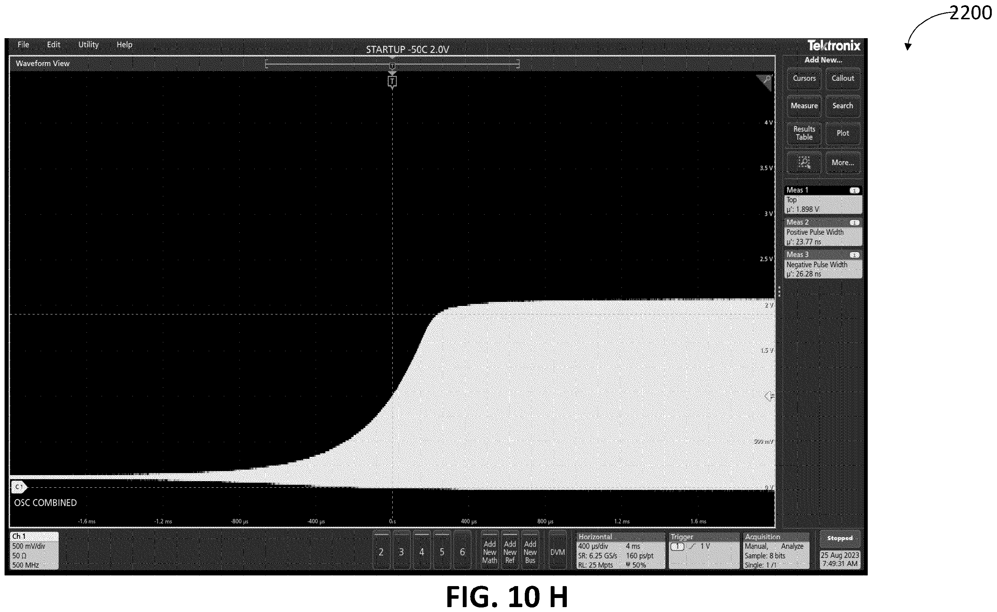

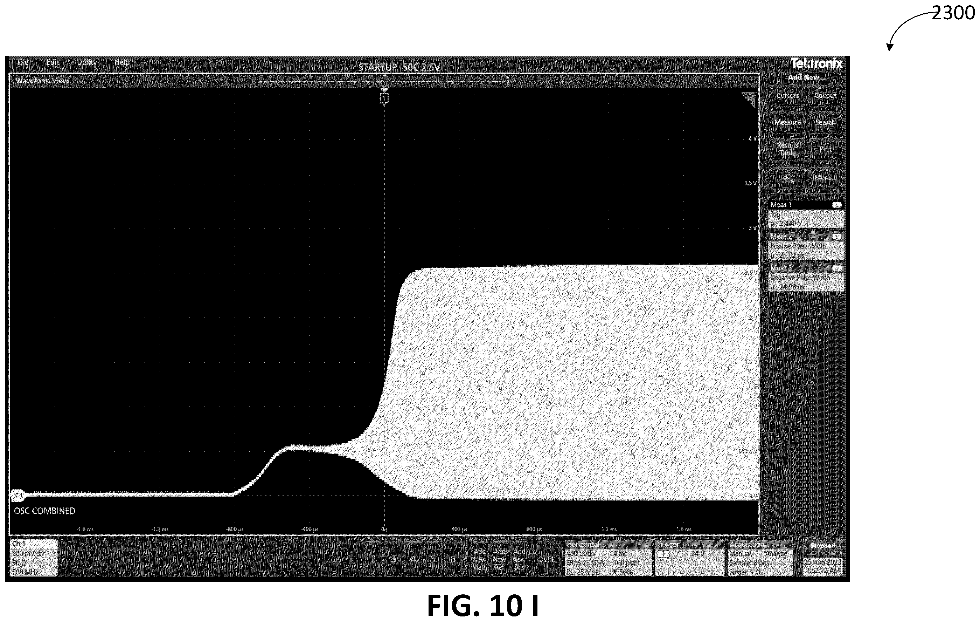

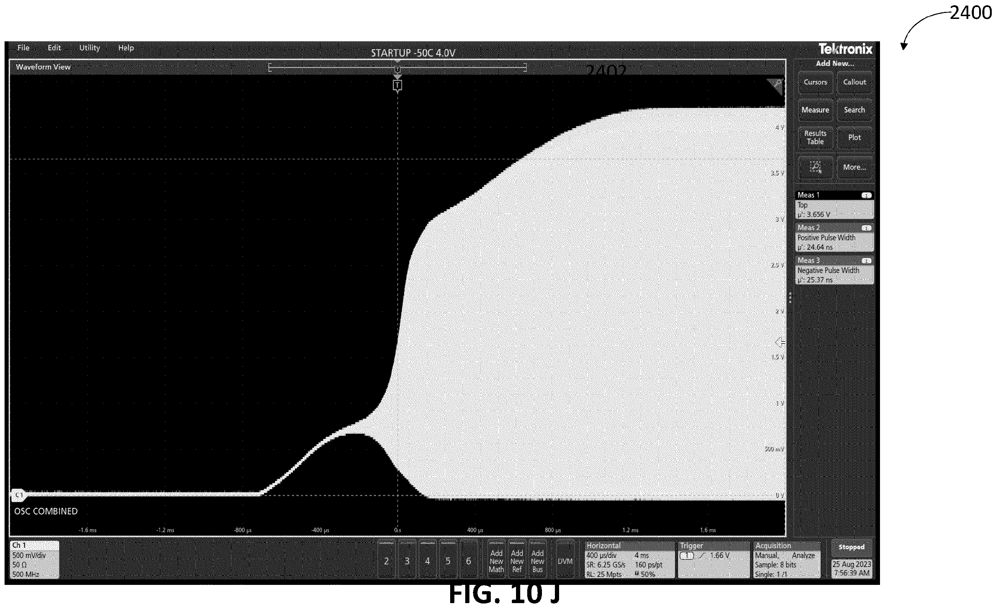

FIG. 10A through FIG. 10 J are screenshots from oscilloscope 406 showing images of the voltage at the combined output 131 from $R_o$ 107, 117, and 127 on the PCB 300 as the power supply voltage ramps from zero to various power supply voltages and the oscillators start up, in accordance with one or more embodiments of the disclosure. The images show several combinations of thermal chamber 411 temperatures and power supply voltage. The power supply voltage ramp starts at times 1501, 1601, 1701, 1801, 1901, 2001, 2101, 2201, 2301, and 2401 and the oscillators reach the full output level at times 1502, 1602, 1702, 1802, 1902, 2002, 2102, 2202, 2302, and 2402. FIG. 10A shows start up at 2.0 volts and ambient temperature in approximately 2 milliseconds. FIG. 10B shows start up at 3.3 volts and ambient temperature in approximately 1.7 milliseconds. FIG. 10C shows start up at 4.0 volts and ambient temperature in approximately 1.8 milliseconds. FIG. 10D shows start up at 2.0 volts and 100 degrees Celsius in approximately 1.9 milliseconds. FIG. 10E shows start up at 2.5 volts and 100 degrees Celsius in approximately 0.8 milliseconds. FIG. 10F shows start up at 3.3 volts and 100 degrees Celsius in approximately 1.0 milliseconds. FIG. 10G shows start up at 4.0 volts and 100 degrees Celsius in approximately 2.2 milliseconds. FIG. 10H shows start up at 2.0 volts and -50 degrees Celsius in approximately 2.0 milliseconds. FIG. 10I shows start up at 2.5 volts and -50 degrees Celsius in approximately 0.8 milliseconds. FIG. 10J shows start up at 4.0 volts and -50 degrees Celsius in approximately 1.0 milliseconds

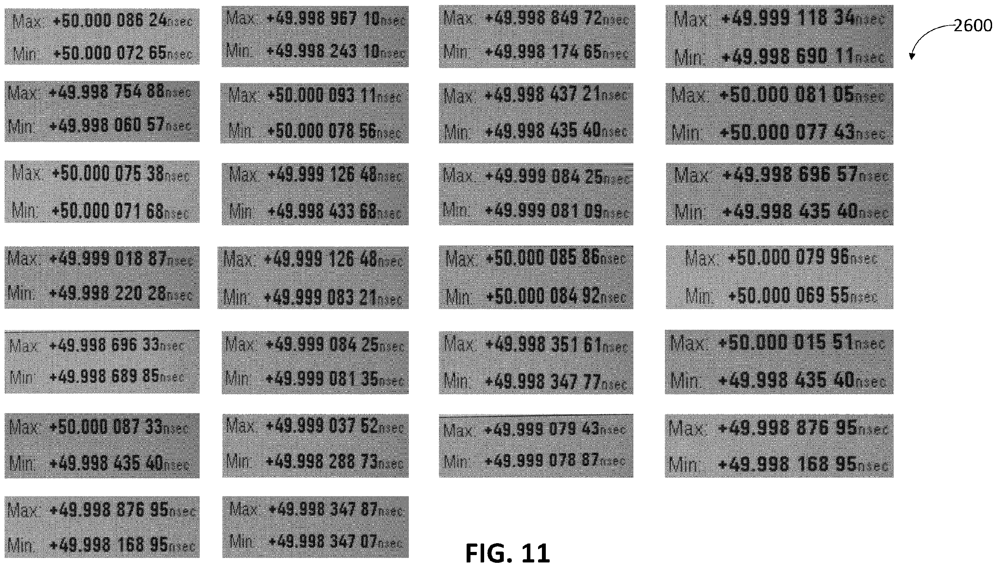

FIG. 11 shows snippets of the display on frequency counter 403 measuring the combined output 131 from the PCB 300 circuit for various combinations of power supply voltage, temperature, and forced upset. The longest maximum period and the shortest minimum period across all voltage, temperature, and upset combinations determines the output range in frequency of the oscillator during testing.

## Claims

1. A circuit for synchronizing oscillators, the circuit comprising:

> a power supply voltage source (VDD);
> at least three oscillators (108, 118, 128) having respective inputs connected to a first single node;
> at least three inverting buffers (104, 114, 124), each inverting buffer having a respective input connected to an output of a corresponding oscillator of the at least three oscillators;
> at least three summing resistors (107, 117, 127), each summing resistor having a first end connected to an output of a corresponding inverting buffer of the at least three inverting buffers;
> a combined output created by connecting second ends of the at least three summing resistors to a single second node.

2. The circuit of claim 1, wherein each of the at least three oscillators comprise a CMOS unbuffered inverter (102, 112, 122), a bias resistor (105, 115, 125), a crystal (101, 111, 121), an output resistor (103, 113, 123) connecting to the crystal input, a crystal input capacitor (106, 116, 126), and a crystal output capacitor (109, 119, 129).

3. The circuit of claim 2, wherein each of the at least three oscillators oscillates at a similar frequency based at least in part on the crystals of the at least three oscillators having a similar resonant frequency, the input capacitors of the at least three oscillators having a similar capacitance, the output capacitors of the at least three oscillators having a similar capacitance, a stray capacitance in the physical implementation of the circuit, and the output resistors of the at least three oscillators having a similar resistance.

4. The circuit of claim 3, wherein the combined output starts up synchronously without a settling time after application of power in response to the second ends of the at least three summing resistors being connected to the single second node at the combined output and the at least three oscillators being connected to the single first node at inputs to each of the at least three crystals.

5. The circuit of claim 1, wherein each of the at least three inverting buffers comprises a CMOS unbuffered inverter.

6. The circuit of claim 1, further comprising a processor configured to prevent an upset to one or more of the at least three oscillators or an upset to one or more of the at least three inverting buffers from causing the combined output voltage level to cross a discrimination threshold.

**7.** The circuit of claim 6, wherein the discrimination threshold is based at least in part on the power supply voltage (VDD).

**8.** The circuit of claim 7, wherein the discrimination threshold is based on half of the power supply voltage (VDD).

FIG. 1

EP 4 586 498 A1

**FIG. 2**

FIG. 3A

**FIG. 3B**

EP 4 586 498 A1

FIG. 3C

FIG. 4A

401

312

200

400

**FIG. 4B**

FIG. 4C

FIG. 5

EP 4 586 498 A1

FIG. 6

FIG. 7

EP 4 586 498 A1

**FIG. 8**

FIG. 9A

FIG. B

FIG. 9C

1500

FIG. 10 A

FIG. 10 B

**FIG. 10 C**

EP 4 586 498 A1

FIG. 10 D

1900

FIG. 10 E

FIG. 10 F

**FIG. 10 G**

EP 4 586 498 A1

FIG. 10 H

EP 4 586 498 A1

FIG. 10 I

FIG. 10 J

2600

Max. +49.999 118 34 nsec
Min. +49.998 690 11 nsec

Max. +50.000 081 05 nsec
Min. +50.000 077 43 nsec

Max. +49.998 696 57 nsec
Min. +49.998 435 40 nsec

Max. +50.000 079 96 nsec
Min. +50.000 069 55 nsec

Max. +50.000 015 51 nsec
Min. +49.998 435 40 nsec

Max. +49.998 876 95 nsec
Min. +49.998 168 95 nsec

Max. +49.998 849 72 nsec
Min. +49.998 174 65 nsec

Max. +49.998 437 21 nsec
Min. +49.998 435 40 nsec

Max. +49.999 084 25 nsec
Min. +49.999 081 09 nsec

Max. +50.000 085 86 nsec
Min. +50.000 084 92 nsec

Max. +49.998 351 61 nsec
Min. +49.998 347 77 nsec

Max. +49.999 079 43 nsec
Min. +49.999 078 87 nsec

Max. +49.998 967 10 nsec
Min. +49.998 243 10 nsec

Max. +50.000 093 11 nsec
Min. +50.000 078 56 nsec

Max. +49.999 126 48 nsec
Min. +49.998 433 68 nsec

Max. +49.999 126 48 nsec
Min. +49.999 083 21 nsec

Max. +49.999 084 25 nsec
Min. +49.999 081 35 nsec

Max. +49.999 037 52 nsec
Min. +49.998 288 73 nsec

Max. +49.998 347 87 nsec
Min. +49.998 347 07 nsec

Max. +50.000 086 24 nsec
Min. +50.000 072 65 nsec

Max. +49.998 754 88 nsec
Min. +49.998 060 57 nsec

Max. +50.000 075 38 nsec
Min. +50.000 071 68 nsec

Max. +49.999 018 87 nsec
Min. +49.998 220 28 nsec

Max. +49.998 696 33 nsec
Min. +49.998 689 85 nsec

Max. +50.000 087 33 nsec
Min. +49.998 435 40 nsec

Max. +49.998 876 95 nsec
Min. +49.998 168 95 nsec

FIG. 11

| | Europäisches Patentamt<br>European Patent Office<br>Office européen des brevets | **EUROPEAN SEARCH REPORT** | **Application Number**<br>EP 25 15 1298 |
|---|---|---|---|

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|---|---|---|---|
| X | US 2010/225403 A1 (BORODITSKY ROMAN [US]<br>ET AL) 9 September 2010 (2010-09-09)<br>* paragraph [0020] - paragraph [0021];<br>figure 1. 2 *<br>----- | 1-8 | INV.<br>H03B5/36 |
| X | US 10 720 906 B2 (BAE SYS INF & ELECT SYS<br>INTEG [US]) 21 July 2020 (2020-07-21)<br>* figures 2, 3 *<br>----- | 1 | |
| A | US 2018/241346 A1 (WU JANNE WHA [TW])<br>23 August 2018 (2018-08-23)<br>* figure 1 *<br>----- | 1 | |

|  |
|---|
| **TECHNICAL FIELDS<br>SEARCHED (IPC)** |
| H03B |

The present search report has been drawn up for all claims

| Place of search | Date of completion of the search | Examiner |
|---|---|---|
| Munich | 28 May 2025 | Schnabel, Florian |

EPO FORM 1503 03.82 (P04C01)

**EP 4 586 498 A1**

## ANNEX TO THE EUROPEAN SEARCH REPORT
## ON EUROPEAN PATENT APPLICATION NO.

EP 25 15 1298

This annex lists the patent family members relating to the patent documents cited in the above-mentioned European search report.
The members are as contained in the European Patent Office EDP file on
The European Patent Office is in no way liable for these particulars which are merely given for the purpose of information.

28-05-2025

| Patent document cited in search report | Publication date | Patent family member(s) | Publication date |
|---|---|---|---|
| US 2010225403 A1 | 09-09-2010 | CN 102342024 A | 01-02-2012 |
| | | EP 2404379 A1 | 11-01-2012 |
| | | EP 3098967 A1 | 30-11-2016 |
| | | JP 5518508 B2 | 11-06-2014 |
| | | JP 5707477 B2 | 30-04-2015 |
| | | JP 2010206784 A | 16-09-2010 |
| | | JP 2014075818 A | 24-04-2014 |
| | | US 2010225403 A1 | 09-09-2010 |
| | | WO 2010101779 A1 | 10-09-2010 |
| US 10720906 B2 | 21-07-2020 | EP 3837770 A1 | 23-06-2021 |
| | | US 2020014371 A1 | 09-01-2020 |
| | | WO 2020009833 A1 | 09-01-2020 |
| US 2018241346 A1 | 23-08-2018 | NONE | |

EPO FORM P0459

For more details about this annex : see Official Journal of the European Patent Office, No. 12/82

**REFERENCES CITED IN THE DESCRIPTION**

**Patent documents cited in the description**

- US 63620174